# FASCICULE DE BREVET EUROPEEN

(11) **EP 0 353 114 B1**
(45) Date de publication et mention de la délivrance du brevet: **08.06.1994**
(21) Numéro de dépôt: 89401833.2
(22) Date de dépôt: 27.06.1989
(51) Int. Cl.: H01L 23/485

(54) **Dispositif d'interconnexion entre un circuit intégré et un circuit électrique et procédé de fabrication du dispositif**
Verbindungsvorrichtung zwischen einer integrierten Schaltung und einer elektrischen Schaltung und Herstellungsverfahren derselben
Interconnection device between an integrated circuit and an electrical circuit and method of manufacturing the device

(30) Priorité: 13.07.1988 FR 8809547
(43) Date de publication de la demande: 31.01.1990
(73) Titulaire: THOMSON-CSF, 75008 Paris (FR)
(72) Inventeur: Prevost, Michel, F-92045 Paris la Défense (FR)
(74) Mandataire: Benoit, Monique

(56) Documents cités:
- EP-A- 0 226 443
- EP-A- 0 268 111
- EP-A- 0 284 820
- EP-A- 0 285 064
- EP-A- 0 308 714
- US-A- 4 417 392
- IBM TECHNICAL DISCLOSURE BULLETIN, vol. 14, no. 4, septembre 1971, pages 1316-1317, New York, US; E.C. LAYDEN: "Use of relatively diagonal and rectangular wiring planes in multilayer packages"
- IBM TECHNICAL DISCLOSURE BULLETIN, vol. 28, no. 3 août 1985, pages 1184-1185, New York, US; "Chip carrier of prefabricated glass layers provided with inner vias and conductors"

## Description

La présente invention a pour objet un dispositif d'interconnexion entre un circuit intégré (noté CI) et un circuit électrique (noté CE), comme par exemple un circuit imprimé (noté CImp), le CE comportant une face sensiblement parallèle à la face active du CI. Le dispositif est susceptible de relier au moins un plot du CI et un point de connexion du CE qui sont décalés l'un par rapport à l'autre dans un plan abstrait (dit "de référence") sensiblement parallèle à la face active du CI. Ainsi quelle que soit la correspondance désirée entre les plots du CI et les points de connexion du CE, le dispositif permet d'assurer une réduction notable du nombre ou de la longueur des pistes réalisées dans ou sur le CI ou le CE, grâce à un choix judicieux de déplacements, dans le plan de référence, au sein du dispositif lui-même, un tel choix étant susceptible d'être programmé. L'invention a aussi pour objet un procédé de fabrication d'une partie de ce dispositif à partir d'un nombre préfixé de modules d'un seul type.

Les dimensions relatives des plots d'une face active d'un CI et des points de connexion d'un CE, comme par exemple un CImp monocouche ou multicouches, excluent la possibilité de connecter directement le CI au CE : il est nécessaire d'interconnecter le CI et le CE au moyen d'un dispositif dont la finesse de connexion est intermédiaire entre celle du CI et celle du CE. Un tel dispositif occupe nécessairement de la place et complique la manoeuvre d'interconnexion.

D'autre part, la correspondance désirée entre les plots du CI et les points de connexion du CE peut impliquer une réalisation de pistes supplémentaires.

On connaît des dispositifs d'interconnexion entre un CI et un CE comportant une embase fabriquée dans un matériau isolant, située entre le CI et le CE, dont les dimensions dans ledit plan de référence sont largement supérieures à celles du CI, sur laquelle est fixée le CI du côté opposé à sa face active ; l'interconnexion désirée est assurée au moyen de fils conducteurs d'électricité (dits "die bonding" et dont la finesse est du même ordre de grandeur que celle des plots du CI) reliant les plots du CI à des pistes conductrices d'électricité (dont la finesse de réalisation est intermédiaire entre celle des plots du CI et celle des points de connexion du CE) qui sont réalisées sur et/ou au sein de l'embase, ces pistes divergeant autour du CI par exemple vers des pattes, qui sont destinées à être fichées dans des trous d'un CImp. Il est également connu de munir une telle embase, non pas de pattes, mais de plots, placés à la périphérie de la face de l'embase située en regard du CE, reliés auxdites pistes par exemple au moyen d'une métallisation partielle des côtés de l'embase, et destinés à être soudés aux points de connexion du CE.

Ces dispositifs connus présentent néanmoins de multiples inconvénients :
- à cause de leur finesse, les fils de bonding sont fragiles ; pour minimiser cette fragilité, ces fils sont aussi courts que possible et n'atteignent que des endroits situés à la périphérie de la face active du CI (autrement dit, les plots du CI sont périphériques) : ceci, d'une part limite le nombre de plots d'un CI de surface donnée, et d'autre part implique la réalisation de pistes (dans et/ou sur le CI) reliant des zones situées au centre de la face active du CI à la périphérie de celle-ci ;
- toujours à cause de leur finesse, les fils de bonding sont délicats à connecter, tant aux plots du CI qu'aux pistes de l'embase ;
- les fils de bonding sont connectés un par un, ce qui prend du temps ;
- les dimensions de l'embase dans le plan de référence étant supérieures à celles du CI, le dispositif d'interconnexion est encombrant ;
- ce dispositif d'interconnexion ne permet pas de compenser une éventuelle complexité de la correspondance désirée entre les plots du CI et les points du CE.

On connaît par ailleurs des dispositifs d'interconnexion entre un CI et un CE comportant des couches de matériau diélectrique pourtant des voies conductrices et des vias conducteurs. Ainsi l'article paru dans IBM Technical Disclosure Bulletin, vol. 28, N° 3, août 1985, pages 1184-1185 décrit un dispositif multicouche de connexion entre une puce de semiconducteurs et une couche de base portant des broches, qui correspond à un dispositif selon la partie précaractérisante de la revendication 1. Le dispositif comporte au moins une couche intermédiaire diélectrique traversée de vias conducteurs sur les deux faces de laquelle sont appliqués des motifs de pistes conductrices selon une technique classique de réalisation de circuits imprimés. Ces motifs sont déterminés en fonction des distributions d'alimentation et de signal à réaliser puis les extrémités de vias d'une face d'une couche sont soudées à des pistes adéquates de la face en vis-à-vis de la couche adjacente.

Une autre solution connue d'après la demande de brevet européen EP-A-0 268 111 consiste, pour interconnecter des puces de semiconducteur et un substrat commun d'interconnexion, à interposer plusieurs feuilles diélectriques portant chacune des pistes de conducteurs parallèles déposés par métallisation et permettant les interconnexions voulues à l'aide de vias conducteurs percés ou interrompus dans certaines des couches.

Dans les deux cas, il est nécessaire de réaliser soit des dessins de pistes spécifiques soit des perçages et métallisations de vias spécifiques caractéristiques de l'interconnexion à réaliser. Ainsi la fabrication de chaque couche nécessite des opérations différentes selon des techniques de réalisation relativement complexes et coûteuses.

L'invention se propose donc de remédier aux inconvénients résultant de l'utilisation de fils de bonding tout en recourant à un dispositif très simplifié de fabrication aisée et peu coûteuse grâce à une standardisation très poussée des éléments d'interconnexion prévus.

Ces inconvénients sont éliminés par un dispositif d'interconnexion entre un circuit intégré et un circuit électrique et un procédé de fabrication tels que définis dans les revendications 1 et 7, respectivement. Des modifications avantageuses sont définies dans les revendications dépendantes 2 à 6, 8 et 9.

Des précisions, des particularités et différentes modes de réalisation de l'invention apparaîtront au cours de la description qui suit, à l'aide des figures annexées qui représentent :
- la figure 1, une vue en coupe d'un dispositif connu d'interconnexion entre un CI et un CE ;
- la figure 2, une vue de dessus du dispositif connu de la figure 1 ;
- la figure 3, un schéma en éclaté d'un mode de réalisation du dispositif selon l'invention, situé entre les deux circuits (CI et CE) qu'il relie ;
- la figure 4, un schéma en éclaté d'un mode de réalisation préféré du dispositif selon l'invention, situé entre les deux circuits (CI et CE) qu'il relie ;
- la figure 5, une vue détaillée et en perspective d'une première variante du dispositif de la figure 4 dessiné isolément, et représenté en cours de fabrication ;
- la figure 6, une partie des éléments de la figure 5 ;
- la figure 7, une vue non détaillée et en perspective éclatée d'une seconde variante du dispositif de la figure 4, dessiné isolément ;
- la figure 8, un schéma synoptique d'une première variante d'un procédé de fabrication d'une lamelle du dispositif selon l'invention ;
- la figure 9, un schéma synoptique d'une partie d'une seconde variante d'un procédé de fabrication d'une lamelle du dispositif selon l'invention ;
- la figure 10, une vue de dessus illustrant des variantes du dispositif de la figure 4, dessiné isolément.

Sur ces différentes figures, d'une part l'échelle réelle n'a pas été respectée, et d'autre part les mêmes références se rapportent aux mêmes éléments.

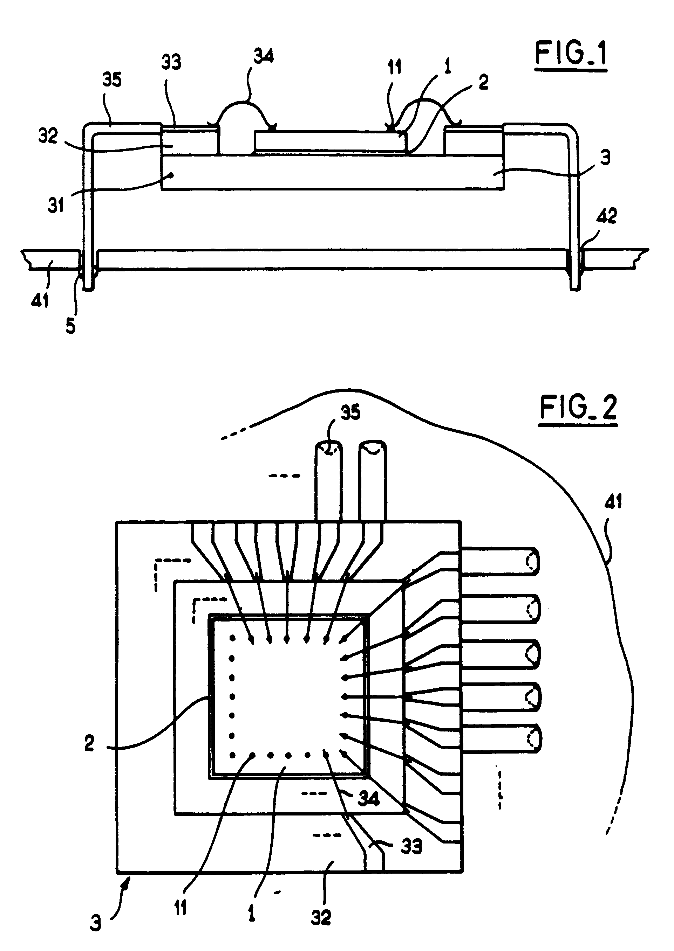

Un dispositif connu et précédemment décrit est illustré, respectivement en coupe et vu de dessus, sur les figures 1 et 2. Un CI 1 est fixé par de la colle 2 à une embase 3 : cette embase 3 comporte une plaquette support 31, portant le CI 1 sur sa face supérieure, recouverte par une plaquette annulaire 32, disposée sur la plaquette support 31 et autour du CI 1 ; la face active du CI 1 est placée à l'opposé de l'embase 3, et porte des plots périphériques 11 ; ces plots sont reliés, au moyen de fils de bonding 34 (qui sont soudés à chacune de leurs extrémités) à des pistes conductrices d'électricité 33, qui sont réalisées par sérigraphie sur la plaquette annulaire 32 ; ces pistes 33 divergent (comme le montre la figure 2) vers des pattes 35 (qui sont soudées aux pistes 33) ; ces pattes 35 sont par exemple fichées dans les trous 42 d'un circuit imprimé 41 et soudées à celui-ci au moyen de soudures 5 selon un procédé connu en lui-même.

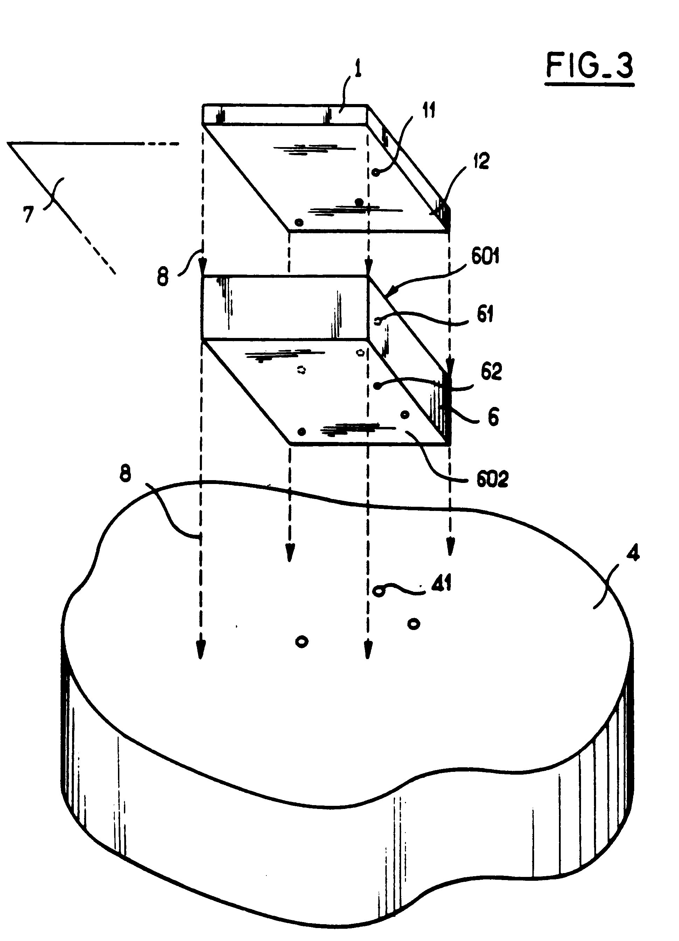

La figure 3 schématise en éclaté un mode de réalisation du dispositif 6 selon l'invention. Ce dispositif 6 assure l'interconnexion entre un CI 1, comportant un nombre k de plots 11 situés sur sa face active 12 (cette face 12 définissant un plan abstrait de référence 7 comme cela a été expliqué dans ce qui précède) et un CE 4, comportant par exemple le même nombre k de points de connexion 41 qui se trouvent sur une surface sensiblement parallèle audit plan de référence. Le dispositif 6 comporte une lamelle dont une première face 601, est située en regard de la face active 12 du CI 1, et dont une seconde face 602 est située en regard de ladite surface du CE 4, ces faces 601 et 602 étant sensiblement parallèles au plan de référence. La lamelle est réalisée dans un matériau électriquement isolant et dont le coefficient de dilatation thermique est avantageusement sensiblement égal à celui du CI 1. Les dimensions de la lamelle dans le plan de référence sont avantageusement sensiblement les mêmes que celles du CI 1 qui est par exemple carré. Sur les faces 601 et 602 se trouvent respectivement des plots 61 et 62, disposés respectivement en face des plots 11 du CI 1 et des points de connexion 41 du CE 4, et dont la finesse est intermédiaire entre celle des plots 11 du CI 1 et celle des points de connexion 41 du CE 4. Les plots 61 de la première face 601 sont reliés, par exemple de façon biunivoque, à ceux 62 de la seconde face 602 par des voies conductrices d'électricité fusibles (non représentées sur cette figure 3) dont au moins une relie un plot 61 donné (de la première face 601) à un plot 62 donné (de la seconde face 602) décalé dans le plan de référence 7 par rapport au plot 61 considéré. Sur cette figure 3, le CI 1, le dispositif 6, et le CE 4 sont représentés écartés les uns des autres, mais ces éléments sont en réalité en contact les uns des autres, comme l'indiquent les flèches discontinues 8. Un tel contact est assuré par des moyens d'assemblage, constitués par exemple de brasures réalisées au niveau de chaque couple de plots (11, 61) et de chaque couple de plot et point de connexion (62, 41) : des microvolumes d'un matériau conducteur d'électricité sont, soit déposés, soit obtenus par croissance cristalline, sur l'un et/ou l'autre plots et/ou points de connexion qui doivent être en contact ; ces microvolumes sont ensuite soudés aux plots et/ou points de connexion qui les environnent. Toutes les brasures correspondant à la mise en contact du CI et du dispositif 6, respectivement du dispositif 6 et du CE, c'est-à-dire toutes les brasures effectuées au niveau des couples de plots (11, 61), respectivement au niveau des couples de plot et point de connexion (62, 41), sont réalisées en une seule opération.

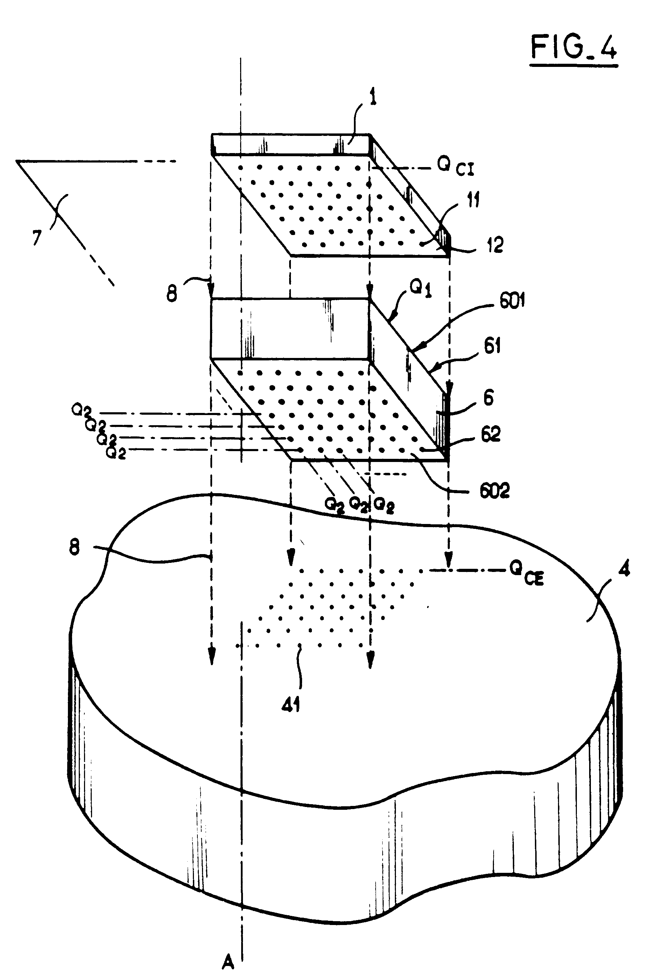

La figure 4 schématise en éclaté un mode de réalisation préféré du dispositif 6 selon l'invention pour lequel les plots 11 du CI, ceux 61 et 62 des faces 601 et 602 du dispositif 6, et les points de connexion 41 du CE 4, sont respectivement disposés aux sommets de quatre quadrillages Q_{CI}, Q₁, Q₂ et Q_{CE}. Ces quatre quadrillages Q_{CI}, Q₁, Q₂ et Q_{CE} sont sensiblement :
- réguliers ;
- identiques ;
- identiquement orientés ;
- non décalés les uns par rapport aux autres, comme l'indique l'axe A. Selon ce mode de réalisation préféré, le CI 1 et le dispositif 6 sont de préférence carrés. Le reste de la description de la figure 4 est analogue à celle de la figure 3.

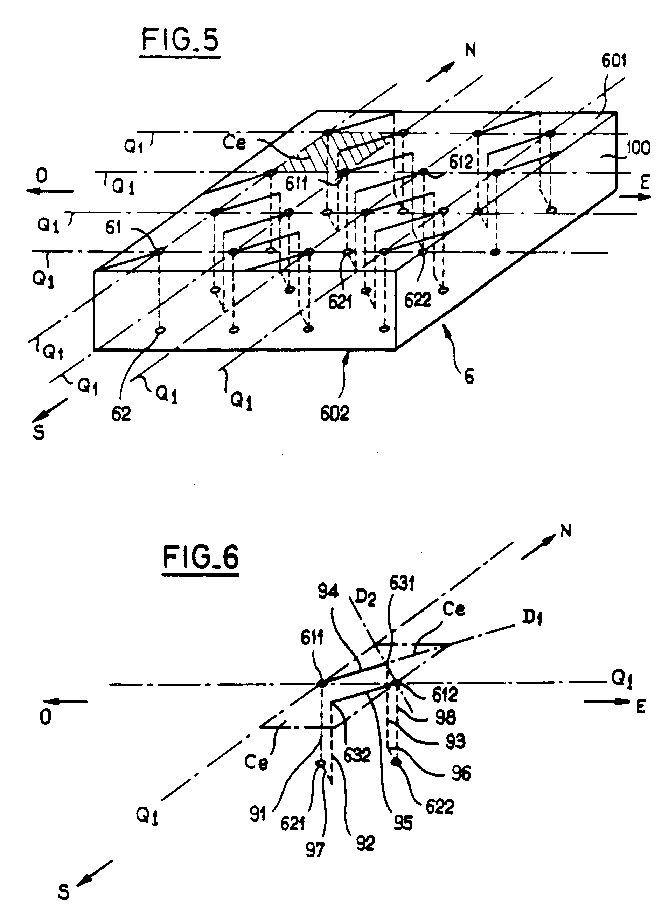

La figure 5 illustre de façon détaillée une première variante du dispositif 6 de la figure 4, dessiné isolément et représenté en cours de fabrication : avant son utilisation, ce dispositif est destiné à subir un traitement (exposé dans ce qui suit), qui dépend de la correspondance désirée entre les plots du CI et les points de connexion du CE. Ce dispositif 6 comporte une lamelle 100, dite de décalage et appelée "strate matricielle de décalage" (et notée SMDP) à cause du fait qu'elle comporte moins une voie conductrice d'électricité reliant un plot 61 donné (de la première face 601) à un plot 62 donné (de la seconde face 602) décalé par rapport au plot 61 considéré, comme cela a été spécifié dans ce qui précède. Plus précisément, comme illustré sur la figure 6 qui représente une partie des éléments de la figure 5, une voie conductrice d'électricité est susceptible de relier :
- soit un plot 611 (respectivement 612), situé sur la première face 601, à un plot 621 (respectivement 622), situé sur la seconde face 602 de la lamelle, non décalé (autrement dit, décalé d'un nombre p = 0 de pas du quadrillage Q₁ de la première face 601) par rapport au plot 611 (respectivement 612) de la première face 601 ;
- soit un plot 611 (respectivement 612), situé sur la première face 601, à un plot 622 (respectivement 621), situé sur la seconde face 602 de la lamelle, décalé d'un nombre p = 1 de pas du quadrillage Q₁ de la première face 601 dans une des deux directions de ce quadrillage Q₁.

Les quatre points cardinaux géographiques (nord, est, sud, ouest respectivement notés N, E, S, O) sont attribués à la SMDP 100 afin de faciliter la description du dispositif 6 et de ses divers éléments.

Une voie conductrice d'électricité sans décalage comporte un chemin transversal 91, dit "direct", (respectivement 98), sensiblement rectiligne et sensiblement perpendiculaire au plan de référence 7, passant par un sommet 611 (respectivement 612) du quadrillage Q₁ de la première face 601.

Une voie conductrice d'électricité avec un décalage comporte dans cet ordre :
- une piste longitudinale 94 (respectivement 95), sensiblement rectiligne, réalisée sur la première face 601, sensiblement parallèle à une première diagonale D₁ du quadrillage Q₁ (parallèle à la direction S/O - N/E) et dont la longueur est égale à la moitié de la diagonale d'un carré élémentaire Ce du quadrillage Q₁ ;
- un chemin transversal 93 (respectivement 92), dit "indirect", sensiblement rectiligne et sensiblement perpendiculaire au plan de référence 7, passant par un centre 631 (respectivement 632) du quadrillage Q₁ de la première face 601 ;
- une piste longitudinale 96 (respectivement 97), sensiblement rectiligne, réalisée sur la seconde face 602, sensiblement parallèle à la seconde diagonale D₂ du quadrillage Q₁ (parallèle à la direction S/E - N/O), et de même longueur que la piste longitudinale 94 (respectivement 95).

Au cours de la description des figures 5 et 6, le quadrillage Q₁ de la première face 601 a été arbitrairement pris comme référence, mais celui Q₂ de la seconde face 602 aurait pu jouer le même rôle.

Au stade de fabrication du dispositif 6 illustré sur les figures 5 et 6, chaque plot 611 (respectivement 612) de la première face 601 est relié d'une part à un plot 621 (respectivement 622) non décalé, et d'autre part à un plot 622 (respectivement 621) décalé d'un nombre p = 1 de pas du quadrillage Q₁ dans la direction E - O : les plots de la SMDP 100 sont donc regroupés par quatre (deux plots analogues aux plots 611 et 612, et deux plots analogues aux plots 621 et 622).

Selon l'interconnexion désirée entre le CI et le CE, et en vue de minimiser le nombre ou la longueur des pistes réalisées dans ou sur le CI ou le CE, on choisit pour chacun de ces groupes de quatre plots, deux trajets. Ce choix est susceptible d'être programmé. Les voies conductrices d'électricité fusibles correspondant à des trajets non choisis sont grillées. Selon la première variante illustrée par les figures 5 et 6 il est possible :
- soit de relier le plot 621 au plot 611, et le plot 622 au plot 612, ce qui revient à griller les deux voies conductrices d'électricité constituées respectivement des pistes longitudinales 94, 96 et 95, 97 d'une part, et des chemins transversaux indirects 93 et 92 d'autre part ;
- soit de relier le plot 622 au plot 611 et le plot 621 au plot 612, ce qui revient à griller les deux voies constituées respectivement des chemins transversaux directs 91 et 98.

Comme cela a été expliqué précédemment, la SMDP 100 comporte au moins une voie conductrice d'électricité avec un décalage, c'est-à-dire au moins un groupement de quatre plots 611, 612, 621, 622 reliés selon le second choix.

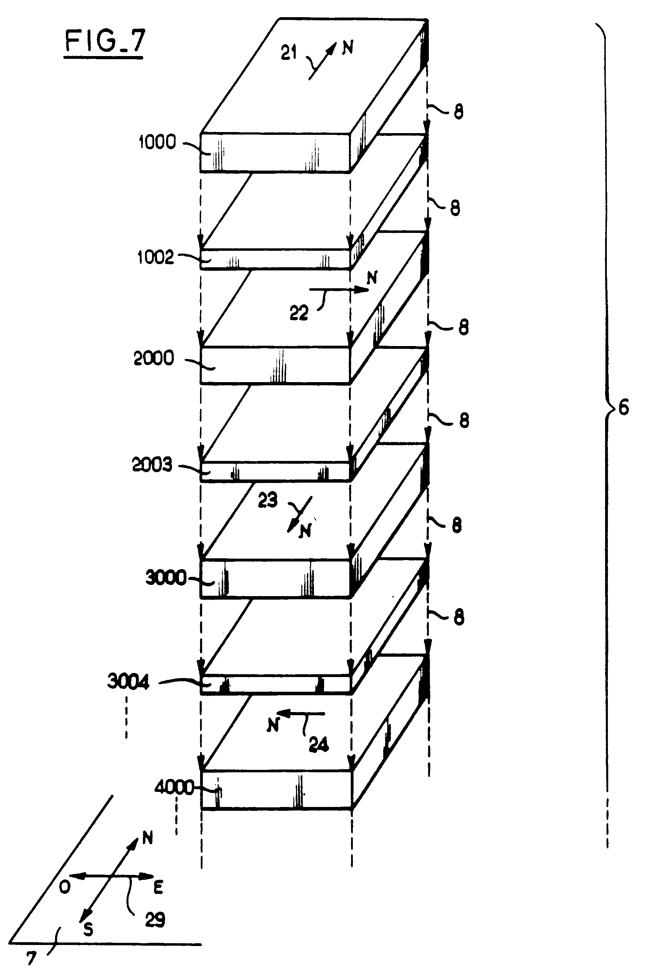

La figure 7 donne une vue en perspective non détaillée d'une seconde variante du dispositif 6 de la figure 4 dessiné isolément. Ce dispositif comporte un nombre n de lamelles de préférence carrées d'un premier type 1000, 2000, 3000, 4000, . . ., séparées par un nombre n-1 de lamelles de préférence carrées d'un second type 1002, 2003, 3004, . . . . . Ces lamelles d'un premier type sont sensiblement identiques à la SMDP 100 des figures 5 et 6 et sont également appelées SMDP. La correspondance entre les plots d'une première face et les plots de la seconde face de chacune des lamelles du premier type, c'est-à-dire le choix des trajets au sein de chacune de ces SMDP, est propre à chacune de ces SMDP. Plus précisément, chaque lamelle du premier type est susceptible d'introduire, pour chaque groupement de quatre plots analogues à ceux 611, 612, 621, 622 des figures 5 et 6, un décalage dans la direction E-O des quatre points cardinaux N, E, S, O qui lui sont propres (sur la figure 7 seul le point cardinal N 21, 22, 23, 24 de chaque SMDP du premier type 1000, 2000, 3000, 4000 a été dessiné). Une combinaison du choix des trajets au sein de chaque SMDP, de l'orientation des SMDP 1000, 2000, 3000, 4000, . . ., les unes par rapport aux autres, et du nombre n de SMDP, est donc susceptible d'assurer n'importe quelle correspondance entre les plots de la première face de la SMDP 1000 qui est située en regard de la face active du CI, et ceux de la seconde face de la SMDP qui est située en regard du CE : sur le cas particulier illustré par la figure 7, dans un repère fixe 29 correspondant aux quatre points cardinaux N, E, S, O du plan de référence 7 :
- la lamelle 1000 assure au moins un décalage E-O ;
- la lamelle 2000 assure au moins un décalage N-S ;
- la lamelle 3000 assure au moins un décalage E-O ;
- la lamelle 4000 assure au moins un décalage N-S.

D'après la configuration des SMDP 1000, 2000, 3000, 4000, . . ., il est par ailleurs indispensable d'intercaler, entre ces SMDP, des lamelles d'un second type 1002, 2003, 3004, . . ., qui ont pour fonction d'isoler les pistes longitudinales de la seconde (respectivement première) face d'une SMDP donnée, de celles de la première face (respectivement seconde) d'une SMDP adjacente. Les lamelles du second type sont appelées "strates d'isolation" (et notées SI) ; elles sont analogues à la SMDP 100 des figures 5 et 6 mais ne comportent que des chemins transversaux directs. L'épaisseur des SI 1002, 2003, 3004, . . ., est avantageusement inférieure à celle des SMDP 1000, 2000, 3000, 4000, . . ., afin de réduire la dimension du dispositif 6 perpendiculairement au plan de référence 7 : en effet, les SI (contrairement aux SMDP) ne présentent pas de risques de claquage entre des pistes longitudinales situées de part et d'autre d'une même lamelle.

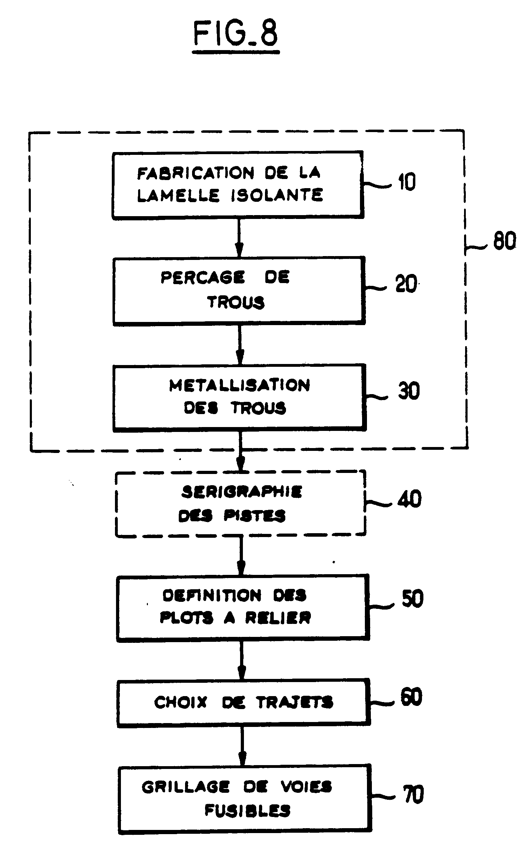

Un schéma synoptique d'une première variante d'un procédé de fabrication d'une lamelle du dispositif selon l'invention est illustré sur la figure 8. Ce schéma représente les étapes de fabrication d'une SMDP analogue à celles 1000, 2000, 3000, 4000, . . ., de la figure 7, ou à celle 100 de la figure 5.

Ces étapes s'enchaînent de la façon suivante :
- une lamelle dont la surface possède de préférence sensiblement les mêmes dimensions que celles de la face active du CI, est fabriquée selon une méthode connue dans un matériau électriquement isolant, pendant une étape 10 ;
- des trous sont percés, à travers la lamelle, sensiblement perpendiculairement à ses faces, aux sommets et aux centres d'un quadrillage sensiblement régulier, durant une étape 20 ;
- la surface interne de ces trous est recouverte d'une couche conductrice d'électricité : comme par exemple du métal, ce qui constitue une étape 30 ;
- des pistes conductrices d'électricité sont réalisées, par exemple par sérigraphie, sur chacune des faces de la lamelle, selon le dessin correspondant aux figures 5 et 6 pendant une étape 40 ;
- une définition des plots de chacune des faces de la lamelle que l'on désire relier constitue une étape 50 (cette définition est fonction de la correspondance désirée entre les plots du CI et les points de connexion du CE) ;
- des trajets sont choisis selon cette définition pendant une étape 60 ; ces trajets comportent des traversées de la lamelle dans des trous et des déplacements sur l'une et l'autre face de la lamelle le long desdites pistes sérigraphiées ;
- les trous et pistes conducteurs d'électricité non choisis lors de l'étape 60 précédente sont traités de façon à ne plus conduire l'électricité : ils sont "grillés" ; cette opération constitue l'étape 70.

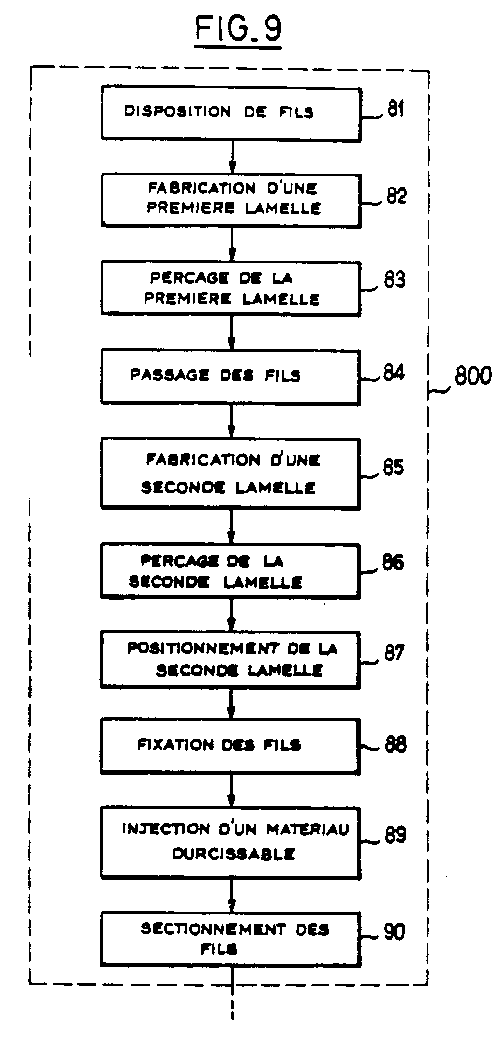

Les étapes 10, 20 et 30, constituant une phase 80 de fabrication d'une lamelle comportant des chemins transversaux, peuvent être remplacées par une phase 800, dont le schéma synoptique est donné par la figure 9, et qui comporte :
- une phase 81 de disposition, d'un nombre b, égal au nombre de sommets et de centres d'un premier quadrillage, de bobines d'un fil conducteur d'électricité, assurant une répartition de b fils aux sommets et aux centres de ce premier quadrillage ;
- une phase (82, 83) de fabrication d'une première lamelle, dite "lamelle-moule", fabriquée dans un matériau n'adhérant pas au matériau isolant, dont la surface est au moins égale à celle de la lamelle du dispositif, comportant b trous, répartis aux sommets et aux centres du premier quadrillage, chacun des trous ayant de préférence une section dont la forme et les dimensions sont sensiblement les mêmes que celle des fils ;
- une phase 84 de passage des b fils respectivement dans les b trous correspondants de la première lamelle-moule ;
- une phase (85, 86) de fabrication et de perçage d'une seconde lamelle-moule, ayant sensiblement les mêmes caractéristiques que la première et comportant en outre des moyens de fixation desdits b fils ;
- une phase 87 de passage des fils dans la seconde lamelle moule et de positionnement de celle-ci ;
- une phase 88 de fixation des b fils respectivement dans les b trous correspondants de ladite seconde lamelle-moule ;
- une phase 89 d'injection d'un matériau durcissable, électriquement isolant, entre les deux lamelles-moules ;
- une phase 90 de sectionnement des b fils, de part et d'autre du matériau durcissable après son durcissement, les b fils constituant lesdits chemins transversaux.

Une SI analogue à celles 1002, 2003, 3004, ..., de la figure 7, est réalisée selon un procédé de fabrication ne comportant que des étapes analogues à celles constituant la phase 80 de la figure 8, ou celle 800 de la figure 9, les trous n'étant en outre réalisés qu'aux sommets du quadrillage.

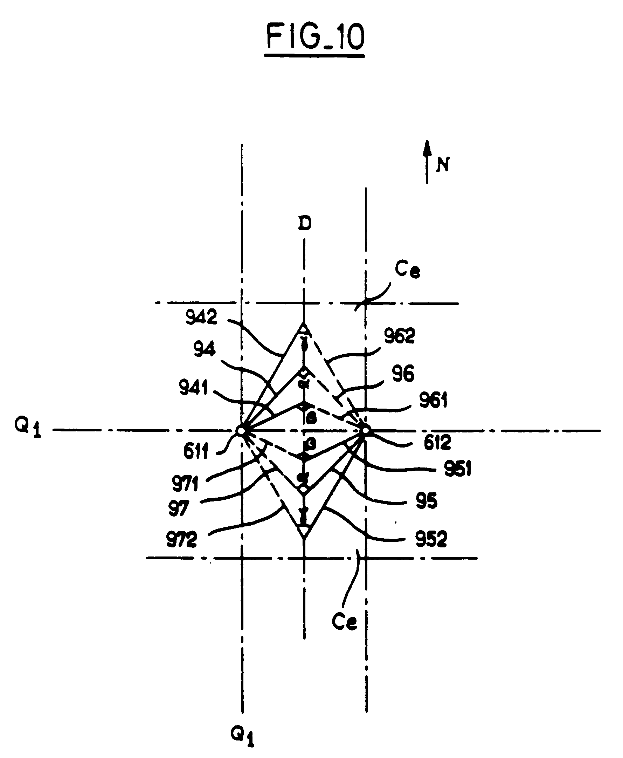

Des variantes des premier et second modes de réalisation du dispositif selon l'invention sont illustrées par la figure 10. Les pistes longitudinales 94 et 96 (respectivement 97 et 95) de la figure 6 font entre-elles un angle droit . L'invention couvre également deux autres configurations, illustrées sur la figure 10, selon lesquelles ces pistes 94 et 96 (respectivement 97 et 95) sont remplacées par des pistes 941 et 961 (respectivement 971 et 951), faisant entre elles un angle obtus , ou bien par des pistes 942 et 962 (respectivement 972 et 952), faisant entre elles un angle aigu . Ces deux types de pistes sont tels que les chemins transversaux indirects -reliant respectivement les pistes 94, 941 ou 942 (respectivement 95, 951 ou 952) situées sur la première face de la lamelle aux pistes 96, 961 ou 962 (respectivement 97, 971 ou 972) situées sur la seconde face de la lamelle- passent par la médiatrice D des positions des deux plots 611 et 612 de la première face.

L'invention couvre aussi des modes de réalisation selon lesquels le pas de décalage p est un entier strictement supérieur à 1.

## Revendications

1. Dispositif (6) d'interconnexion entre un circuit intégré CI (1) comportant des plots (11) disposés sur une face active (12) et un circuit électrique CE (4) comportant une surface sensiblement parallèle à la face active du CI (1), où sont situés des points de connexion (41), ledit dispositif (6), reliant des plots du CI (1) et des points de connexion du CE (4), et comportant :
- au moins une lamelle d'un premier type (100), fabriquée dans un matériau électriquement isolant, placée entre la face active (12) du CI (1) et le CE (4), dont les faces comportent chacune des plots (61, 62, 611, 612, 621, 622), les plots (61, 611, 621) d'une première face (601), située en regard du CI (1), étant disposés en face de ceux (11) du CI (1), et les plots (62, 612, 622) de la seconde face (602), située en regard du CE (4), étant disposés en face des points de connexion (41) du CE (4), ladite lamelle (100) comportant en outre des moyens internes (91 ; 98 ; 94, 93, 96 ; 95, 92, 97), assurant un contact électrique entre les plots (61, 611, 621) de ladite première face (601) et ceux (62, 612, 622) de ladite seconde face (602),
- des moyens d'assemblage par soudure ou brasure assurant un contact électrique, entre les plots (11) du CI (1) et les plots (61, 611, 621) de ladite première face (601) d'une part, et entre les plots (62, 612, 622) de ladite seconde face et les points de connexion (41) du CE (4) d'autre part, lesdits moyens d'assemblage comportant des microvolumes d'un matériau conducteur d'électricité formés sur l'un et/ou l'autre des plots ou points de connexion qui doivent être en contact électrique, chacun desdits microvolumes ayant été soudé aux plots ou points de connexion qui l'environnent, les plots (11) du CI (1), de ladite première face (601), de ladite seconde face (602), et les points de connexion (41) du CE (4) étant respectivement disposés aux sommets de quatre quadrillages (Q_{CI}, Q₁, Q₂, Q_{CE}) réguliers, ces quatre quadrillages étant identiques, identiquement orientés, et non décalés les uns par rapport aux autres dans un plan abstrait de référence (7) parallèle à la face active (12) du CI (1),
le dispositif étant caractérisé en ce que :
- les plots (61, 62, 611, 612, 621, 622) de ladite lamelle (100) sont de finesse intermédiaire entre celle des plots (11) du CI (1) et celle des points de connexion (41) du CE (4),
- lesdits moyens internes (91 ; 98 ; 94, 93, 96 ; 95, 92, 97) assurant un contact électrique comportent un nombre prédéterminé de voies conductrices d'électricité fusibles (91 ; 98) traversant la lamelle (100) sans décalage en des points correspondant auxdits sommets selon un chemin transversal perpendiculaire audit plan de référence (7) et un nombre prédéterminé et non nul de voies conductrices d'électricité fusibles (94, 93, 96 ; 95, 92, 97) traversant la lamelle (100) avec un décalage donné dans ledit plan de référence (7) s'effectuant pour une même lamelle (100) selon l'une des deux directions de l'un des quadrillages (Q₁, Q₂) des faces de la lamelle (100), ledit décalage correspondant à un nombre préfixé entier strictement positif p de pas dudit quadrillage (Q₁, Q₂) ;
- et en ce que lesdites voies conductrices (94, 93, 96 ; 95, 92, 97) avec décalage comportent chacune une première piste longitudinale (94 ; 95), rectiligne, réalisée sur ladite première face (601) parallèlement à une première direction de piste, une seconde piste longitudinale (96 ; 97), rectiligne, réalisée sur ladite seconde face (602) parallèlement à une seconde direction de piste et un chemin transversal (93 ; 92) reliant les extrémités desdites deux pistes longitudinales à travers ladite lamelle (100) perpendiculairement audit plan de référence (7).

2. Dispositif selon la revendication 1, caractérisé en ce que ladite première direction des pistes longitudinales sur la première face (601) et ladite seconde direction des pistes longitudinales sur la seconde face (602) sont symétriques par rapport à la direction de décalage pour la lamelle (100).

3. Dispositif selon l'une des revendications 1 ou 2, caractérisé en ce que le nombre p est égal à 1.

4. Dispositif selon la revendication 3, caractérisé en ce que lesdites première et seconde directions de pistes longitudinales sont respectivement une première diagonale (D₁) et une seconde diagonale (D₂) dudit quadrillage (Q₁, Q₂), et que la longueur de chacune des pistes longitudinales est égale à la moitié d'une diagonale.

5. Dispositif selon l'une des revendications 1 à 4, caractérisé en ce que les dimensions de la lamelle (100) dans ledit plan de référence (7) sont sensiblement égales à celles du CI (1).

6. Dispositif selon l'une des revendications 1 à 5, caractérisé en ce qu'il comporte :
- un nombre n de lamelles dudit premier type (1000, 2000, 3000, 4000) empilées et placées entre la face active (12) du CI (1) et le CE (4), les directions de décalage respectives des lamelles du premier type (1000, 2000, 3000, 4000) étant ou non orientées différemment les unes par rapport aux autres selon le décalage global recherché,
- un nombre n-1 de lamelles d'un second type (1002, 2003, 3004), chacune étant intercalée entre deux lamelles successives du premier type (1000, 2000, 3000, 4000), fabriquées dans un matériau électriquement isolant, dont les faces comportent chacune des plots qui sont de même finesse que celle des plots des lamelles du premier type et sont disposés auxdits sommets, les plots des faces d'une lamelle du second type donnée étant reliés par des voies conductrices d'électricité traversant cette lamelle sans décalage,
- des moyens d'assemblage par soudure ou brasure des microvolumes d'un matériau conducteur d'électricité assurant un contact électrique entre d'une part les plots d'une face d'une lamelle du premier type (1000, 2000, 3000, 4000) et d'autre part les plots d'une lamelle du second type (1002, 2003, 3004).

7. Procédé de fabrication d'une lamelle du premier type pour un dispositif selon l'une des revendications 1 à 5, caractérisé en ce qu'il comporte :
- une étape (10 ; 89) de fabrication dans un matériau isolant de la lamelle ;
- une étape (20, 30 ; 81-88, 90) de réalisation des chemins transversaux conducteurs d'électricité fusibles, traversant la lamelle perpendiculairement à ses faces en des points correspondant auxdits sommets et aux extrémités des pistes longitudinales ;
- une étape (40) de réalisation des pistes longitudinales fusibles, conductrices d'électricité, rectilignes, sur chacune des faces de la lamelle, reliant des extrémités de chemins transversaux ;
- une étape (50) de définition d'une correspondance entre lesdites extrémités situées sur l'une desdites faces et celles situées sur l'autre desdites faces et devant être reliées électriquement ;
- une étape (60) de choix de trajets assurant ladite correspondance, chacun desdits trajets étant réalisé soit au moyen d'un desdits chemins transversaux soit au moyen d'une desdites pistes longitudinales située sur ladite première face, suivie d'un desdits chemins transversaux, suivi d'une desdites pistes longitudinales situées sur ladite seconde face ;
- une étape (70) de destruction des chemins transversaux et des pistes longitudinales qui n'ont pas été choisis.

8. Procédé selon la revendication 7, caractérisé en ce que les étapes de fabrication de ladite lamelle et de réalisation de chemins transversaux comportent :
- une phase (82) de fabrication d'une première lamelle-moule, fabriquée dans un matériau non susceptible d'adhérer audit matériau isolant ;
- une phase (83) de perçage de ladite première lamelle-moule perpendiculairement à ses faces en des points correspondant aux sommets et aux extrémités des pistes longitudinales de la lamelle à fabriquer ;
- une phase (84) de passage de fils conducteurs d'électricité dans les trous de ladite première lamelle-moule ;
- une phase (85, 86) de fabrication d'une seconde lamelle-moule, fabriquée dans le même matériau que la première lamelle-moule et percée de la même façon ;
- une phase (87) de passage desdits fils dans la seconde lamelle-moule et de positionnement de celle-ci parallèlement à ladite première lamelle-moule ;
- une phase (89) d'injection d'un matériau durcissable, électriquement isolant, entre les deux lamelles-moules ;
- une phase (90) de sectionnement des fils, de part et d'autre dudit matériau durcissable après son durcissement, les fils constituant lesdits chemins transversaux et ledit matériau durcissable constituant le matériau isolant de la lamelle.

9. Procédé selon l'une des revendications 7 ou 8, caractérisé en ce que les pistes longitudinales sont réalisées par sérigraphie sur les faces de la lamelle.

## Claims

1. Interconnection device (6) between an integrated circuit IC (1) including lands (11) arranged on an active face (12) and an electrical cicuit EC (4) including a surface substantially parallel to the active face of the IC (1), at which connection points (41) are situated, the said device (6) linking lands of the IC (1) and connection points of the EC (4), and including:
- at least one wafer of a first type (100), fabricated in an electrically insulating material, placed between the active face (12) of the IC (1) and the EC (4), the faces of which each include lands (61, 62, 611, 612, 621, 622), the lands (61, 611, 621) of a first face (601), situated opposite the IC (1), being arranged facing those (11) of the IC (1), and the lands (62, 612, 622) of the second face (602), situated opposite the EC (4), being arranged facing connection points (41) of the EC (4), the said wafer (100) further including internal means (91; 98; 94, 93, 96; 95, 92, 97), providing an electrical contact between the lands (61, 611, 621) of the said first face (601) and those (62, 612, 622) of the said second face (602),
- means of assembly by welding or soldering, providing an electrical contact between the lands (11) of the IC (1) and the lands (61, 611, 621) of the said first face (601) on the one hand and between the lands (62, 612, 622) of the said second face and the connection points (41) of the EC (4) on the other hand, the said assembly means including microvolumes of an electrically conducting material formed on one and/or the other of the lands or connection points which have to be in electrical contact, each of the said microvolumes having been welded to the lands or connection points which surround it, the lands (11) of the IC (1), of the said first face (601), of the said second face (602), and the connection points (41) of the EC (4) being arranged respectively at the vertices of four regular grids (Q_{IC}, Q₁, Q₂ Q_{EC}), these four grids being identical, identically oriented and not offset with respect to one another in an abstract reference plane (7) parallel to the active face (12) of the IC (1),
the device being characterized in that:
- the lands (61, 62, 611, 612, 621, 622) of the said wafer (100) are of a fineness intermediate between that of the lands (11) of the IC (1) and that of the connection points (41) of the EC (4),
- the said internal means (91; 98; 94, 93, 96; 95, 92, 97) providing an electrical contact include a predetermined number of fusible electrically conducting channels (91; 98) passing through the wafer (100) without offset at points corresponding to the said vertices along a transverse path perpendicular to the said reference plane (7), and a predetermined and non-zero number of fusible electrically conducting channels (94, 93, 96; 95, 92, 97) passing through the wafer (100) with a given offset in the said reference plane (7) being effected for the same wafer (100) along one of the two directions of one of the grids (Q₁, Q₂) of the faces of the wafer (100), the said offset corresponding to a predefined, strictly positive, integer number p of pitch of the said grid (Q₁, Q₂);
- and in that the said conducting channels (94, 93, 96; 95, 92, 97) with offset each include a first, straight-line longitudinal track (94; 95), produced on the said first face (601) parallel to a first track direction, a second straight-line longitudinal track (96; 97), produced on the said second face (602) parallel to a second track direction and a transverse path (93; 92) linking the extremities of the said two longitudinal tracks through the said wafer (100) perpendicularly to the said reference plane (7).

2. Device according to claim 1, characterized in that the said first direction of the longitudinal tracks on the first face (601) and the said second direction of the longitudinal tracks on the second face (602) are symmetric with respect to the direction of offset for the wafer (100).

3. Device according to one of claims 1 or 2, characterized in that the number p is equal to 1.

4. Device according to claim 3, characterized in that the said first and second longitudinal track directions are respectively a first diagonal (D₁) and a second diagonal (D₂) of the said grid (Q₁, Q₂), and that the length of each of the longitudinal tracks is equal to half of a diagonal.

5. Device according to one of claims 1 to 4, characterized in that the dimensions of the wafer (100) in the said reference plane (7) are substantially equal to those of the IC (1).

6. Device according to one of Claims 1 to 5, characterized in that it includes:
- a number n of wafers of the said first type (1000, 2000, 3000, 4000) stacked and placed between the active face (12) of the IC (1) and the EC (4), the respective directions of offset of the wafers of the first type (1000, 2000, 3000, 4000) being oriented or not oriented differently with respect to one another according to the overall offset sought,
- a number n-1 of wafers of the second type (1002, 2003, 3004), each being interposed between two successive wafers of the first type (1000, 2000, 3000, 4000), fabricated in an electrically insulating material, the faces of which each include lands which are of the same fineness as that of the lands of the wafers of the first type and are arranged at the said vertices, the lands of the faces of a given wafer of the second type being linked by electrically conducting channels passing through this wafer without offset,
- means of assembly by welding or soldering of the microvolumes of an electrically conducting material providing an electrical contact between, on the one hand, the lands of one face of a wafer of the first type (1000, 2000, 3000, 4000) and, on the other hand, the lands of a wafer of the second type (1002, 2003, 3004).

7. Method of fabricating a wafer of the first type for a device according to one of claims 1 to 5, characterized in that it includes:
- a step (10; 89) of fabricating the wafer in an insulating material;
- a step (20, 30; 81-88, 90) of producing fusible electrically conducting transverse paths, passing through the wafer perpendicularly to its faces at points corresponding to the said vertices and at the extremities of the longitudinal tracks;
- a step (40) of producing straight-line fusible, electrically conducting longitudinal tracks, on each of the faces of the wafer, linking the extremities of transverse paths;
- a step (50) of defining a correspondence between the said extremities situated on one of the said faces and those situated on the other of the said faces and having to be electrically linked;
- a step (60) of choice of routes providing the said correspondence, each of the said routes being produced either by means of one of the said transverse paths or by means of one of the said longitudinal tracks situated on the said first face, followed by one of the said transverse paths, followed by one of the said longitudinal tracks situated on the said second face;
- a step (70) of destruction of the transverse paths and of the longitudinal tracks which have not been chosen.

8. Method according to claim 7, characterized in that the steps of fabricating the said wafer and of producing transverse paths include:
- a phase (82) of fabricating a first wafer mould, fabricated in a material which is not able to adhere to the said insulating material;
- a phase (83) of piercing the said first wafer mould perpendicularly to its faces at points corresponding to the vertices and to the extremities of the longitudinal tracks of the wafer to be fabricated;
- a phase (84) of passing electrically conducting wires into the holes of the said first wafer mould;
- a phase (85, 86) of fabricating a second wafer mould, fabricated in the same material as the first wafer mould and pierced in the same way;
- a phase (87) of passing the said wires into the second wafer mould and of positioning the latter parallel to the said first wafer mould;
- a phase (89) of injecting an electrically insulating hardenable material, between the two wafer moulds;
- a phase (90) of sectioning the wires, on either side of the said hardenable material after its hardening, the wires constituting the said transverse paths and the said hardenable material constituting the insulating material of the wafer.

9. Method according to one of claims 7 or 8, characterized in that the longitudinal tracks are produced by screen printing on the faces of the wafer.

## Patentansprüche

1. Verbindungsvorrichtung (6) zwischen einem integrierten Schaltkreis CI (1), der auf einer aktiven Seite (12) Kontaktbereiche (11) besitzt, und einer elektrischen Schaltung CE (4), die eine im wesentlichen parallel zur aktiven Seite des CI (1) verlaufende Oberfläche besitzt, auf der Anschlußpunkte (41) liegen, wobei die Vorrichtung (6) Kontaktbereiche des CI (1) mit Anschlußpunkten des CE (4) verbindet und aufweist:
- mindestens eine Lamelle eines ersten Typs (100) aus einem elektrisch isolierenden Material, die zwischen der aktiven Seite (12) des CI (1) und dem CE (4) liegt und deren Seiten je Kontaktbereiche (61, 62, 611, 612, 621, 622) besitzt, wobei die Kontaktbereiche (61, 611, 621) einer ersten Seite (601), die dem CI (1) gegenüberliegt, mit den Kontaktbereichen (11) des CI korrespondieren, während die Kontaktbereiche (62, 612, 622) der zweiten Seite (602), die dem CE (4) gegenüberliegt, mit den Anschlußpunkten (41) des CE (4) korrespondieren und wobei die Lamelle (100) weiter innere Mittel (91; 98; 94, 93, 96; 95, 92, 97) aufweist, die einen elektrischen Kontakt zwischen den Kontaktbereichen (61, 611, 621) der ersten Seite (601) und denen (62, 612, 622) der zweiten Seite (602) herstellen,
- Mittel zum Verschweißen oder Verlöten, die einen elektrischen Kontakt zwischen den Kontaktbereichen (11) des CI (1) und den Kontaktbereichen (61, 611, 621) der ersten Seite (601) einerseits und zwischen den Kontaktbereichen (62, 612, 622) der zweiten Seite und den Anschlußpunkten (41) des CE (4) andererseits herstellen, wobei diese Mittel Mikrovolumen eines elektrisch leitenden Materials aufweisen, die auf einen oder den anderen der Kontaktbereiche oder Anschlußpunkte aufgebracht sind, die miteinander in elektrischen Kontakt gebracht werden sollen, wobei jedes der Mikrovolumen an die sie umgebenden Kontaktbereiche oder Anschlußpunkte angelötet worden ist und wobei die Kontaktbereiche (11) des CI (1), der ersten Seite (601) und der zweiten Seite (602) sowie die Anschlußpunkte (41) des CE (4) an den Scheitelpunkten von vier Rastern (Q_{CI}, Q₁, Q₂, Q_{CE}) liegen, die regelmäßig, identisch und identisch orientiert sind sowie zueinander in einer abstrakten Bezugsebene (7) parallel zur aktiven Seite (12) des CI (1) nicht versetzt sind, dadurch gekennzeichnet, daß die Kontaktbereiche (61, 62, 611, 612, 621, 622) der Lamelle (100) hinsichtlich ihrer Finesse zwischen der der Kontaktbereiche (11) des CI (1) und der Anschlußpunkte (41) des CE (4) liegen,
- die inneren Mittel (91; 98; 94, 93, 96; 95, 92, 97), die einen elektrischen Kontakt herstellen, eine vorgegebene Anzahl von schmelzbaren elektrischen Leitwegen (91; 98) durch die Lamelle (100) ohne Versetzung hindurch an Punkten entsprechend den Scheitelpunkten gemäß einem zur Bezugsebene (7) senkrechten Durchlaß und eine vorgegebene Anzahl größer Null von schmelzbaren elektrischen Leitwegen (94, 93, 96; 95, 92, 97) aufweisen, die die Lamelle (100) mit einer auf die Bezugsebene (7) bezogenen Versetzung durchqueren, wobei für eine gegebene Lamelle (100) die Versetzung in einer von zwei Richtungen eines der Raster (Q₁, Q₂) der Seiten der Lamelle (100) erfolgt und einer vorgegebenen positiven ganzen Zahl p von Schritten des Rasters (Q₁, Q₂) entspricht,
- und daß die elektrischen Leitwege (94, 93, 96; 95, 92, 97) mit Versetzung je eine erste geradlinige Längsleiterbahn (94; 95) auf der ersten Seite (601) parallel zu einer ersten Bahnrichtung, eine zweite geradlinige Längsbahn (96; 97) auf der zweiten Seite (602) parallel zu einer zweiten Bahnrichtung und einen Durchlaß (93; 92) aufweisen, der die Enden der beiden Längsbahnen durch die Lamelle (100) hindurch senkrecht zur Bezugsebene (7) verbindet.

2. Vorrichtung nach Anspruch 1, dadurch gekennzeichnet, daß die erste Längsbahnrichtung auf der ersten Seite (601) und die zweite Längsbahnrichtung auf der zweiten Seite (602) symmetrisch bezüglich der Versetzungsrichtung für die Lamelle (100) sind.

3. Vorrichtung nach einem der Ansprüche 1 oder 2, dadurch gekennzeichnet, daß die Zahl p den Wert 1 hat.

4. Vorrichtung nach Anspruch 3, dadurch gekennzeichnet, daß die erste und die zweite Bahnlängsrichtung in einer ersten Diagonale (D₁) und einer zweiten Diagonale (D₂) des Rasters (Q₁, Q₂) verlaufen und daß die Länge jeder Längsbahn gleich der Hälfte einer Diagonale ist.

5. Vorrichtung nach einem der Ansprüche 1 bis 4, dadurch gekennzeichnet, daß die Abmessungen der Lamelle (100) in der Bezugsebene (7) im wesentlichen gleich denen des CI (1) sind.

6. Vorrichtung nach einem der Ansprüche 1 bis 5, dadurch gekennzeichnet, daß sie aufweist:
- n Lamellen des ersten Typs (1000, 2000, 3000, 4000), die zwischen der aktiven Seite des CI (1) und dem CE (4) übereinanderliegen, wobei die Richtungen der jeweiligen Versetzungen der Lamellen des ersten Typs (1000, 2000, 3000, 4000) je nach der gewünschten globalen Versetzung unterschiedlich sind oder nicht,
- (n-1) Lamellen eines zweiten Typs (1002, 2003, 3004), die je zwischen zwei aufeinanderfolgende Lamellen des ersten Typs (1000, 2000, 3000, 4000) eingelegt sind und aus einem elektrisch isolierenden Material bestehen sowie auf ihren Seiten je Kontaktbereiche mit derselben Finesse wie der der Kontaktbereiche der Lamellen des ersten Typs besitzen und an den Scheiteln liegen, wobei die Kontaktbereiche der Seiten einer gegebenen Lamelle des zweiten Typs über elektrische Durchlässe durch diese Lamelle hindurch ohne Versetzung miteinander verbunden sind,
- Mittel zum Verlöten oder Verschweißen der Mikrovolumen eines elektrischen Leitmaterials, das einen elektrischen Kontakt zwischen einerseits den Kontaktbereichen einer Seite einer Lamelle des ersten Typs (1000, 2000, 3000, 4000) und andererseits den Kontaktbereichen einer Lamelle des zweiten Typs (1002, 2003, 3004) gewährleistet.

7. Verfahren zur Herstellung einer Lamelle des ersten Typs für eine Vorrichtung nach einem der Ansprüche 1 bis 5, dadurch gekennzeichnet, daß es aufweist:
- einen Verfahrensschritt (10; 89), in dem die Lamelle aus einem Isoliermaterial hergestellt wird,
- einen Verfahrensschritt (20, 30; 81-88, 90), bei dem elektrisch leitende schmelzbare Durchlässe durch die Lamelle senkrecht zu ihren Seiten an Punkten entsprechend den Scheitelpunkten und den Enden der Längsbahnen hergestellt werden,
- einen Verfahrensschritt (40), in dem schmelzbare geradlinige elektrisch leitende Längsbahnen auf jeder Seite der Lamelle ausgebildet werden, die an die Enden der Durchlässe angeschlossen sind,
- einen Verfahrensschritt (50) der Definition einer Korrespondenz zwischen den auf einer der Seiten liegenden Enden und dem auf der anderen Seite liegenden Enden, die miteinander elektrisch verbunden werden sollen,
- einen Verfahrensschritt (60) der Auswahl der Pfade zur Realisierung dieser Korrespondenz, wobei jeder der Pfade entweder mit Hilfe eines Durchlasses oder mit Hilfe einer der auf der ersten Seite liegenden Längsbahn, gefolgt von einem Durchlaß und gefolgt von einer auf der zweiten Seite liegenden Längsbahn gebildet wird,
- einen Verfahrensschritt (70), bei dem die nicht ausgewählten Durchlässe und Längsbahnen zerstört werden.

8. Verfahren nach Anspruch 7, dadurch gekennzeichnet, daß die Schritte zur Herstellung der Lamelle und zur Ausbildung der Durchlässe aufweisen:
- eine Phase (82) der Herstellung einer ersten Lamellenform aus einem Material, das an dem Isoliermaterial nicht anhaftet,
- eine Phase (83), in der die Lamellenform senkrecht zu ihren Seiten an Punkten entsprechend den Scheiteln und Enden der Längsbahnen der herzustellenden Lamelle durchstochen wird,
- eine Phase (84), in der elektrisch leitende Drähte in die Löcher der ersten Lamellenform eingesteckt werden,
- eine Phase (85, 86), in der eine zweite Lamellenform aus demselben Material wie die erste Lamellenform hergestellt und in gleicher Weise perforiert wird,
- eine Phase (87), in der die Drähte in die zweite Lamellenform hineingesteckt werden und diese zweite Lamellenform parallel zur ersten Lamellenform angeordnet wird,
- eine Phase (89), in der härtbares elektrisch isolierendes Material zwischen die beiden Lamellenformen injiziert wird,
- eine Phase (90), in der die Drähte zu beiden Seiten des härtbaren Materials nach dessen Aushärtung abgeschnitten werden, wobei die Drähte die Durchlässe bilden und das härtbare Material das isolierende Material der Lamelle.

9. Verfahren nach einem der Ansprüche 7 oder 8, dadurch gekennzeichnet, daß die Längsbahnen durch Serigraphie auf den Seiten der Lamelle ausgebildet werden.
